# EUROPÄISCHE PATENTSCHRIFT

(11) **EP 2 739 934 B1**
(45) Veröffentlichungstag und Bekanntmachung des Hinweises auf die Patenterteilung: **01.03.2017**
(21) Anmeldenummer: 12747903.8
(22) Anmeldetag: 23.07.2012
(51) Int. Cl.: F41H 5/04, C30B 29/26

(54) **TRANSPARENTE KOMPOSIT-SCHEIBE FÜR SICHERHEITSANWENDUNGEN**
TRANSPARENT COMPOSITE PANE FOR SAFETY APPLICATIONS
VITRE COMPOSITE TRANSPARENTE POUR APPLICATIONS DE SÉCURITÉ

(30) Priorität: 03.08.2011 DE 102011080378
(43) Veröffentlichungstag der Anmeldung: 11.06.2014
(73) Patentinhaber: Fraunhofer-Gesellschaft zur Förderung der angewandten Forschung e.V., 80686 München (DE)
(72) Erfinder: KRELL, Andreas, 01189 Dresden (DE); STRASSBURGER, Elmar, 79400 Kandern (DE)
(74) Vertreter: Rauschenbach, Marion
(86) Internationale Anmeldenummer: PCT/EP2012/064372
(87) Internationale Veröffentlichungsnummer: WO 2013/017448

(56) Entgegenhaltungen:
- EP-A1- 0 521 473
- EP-A1- 2 275 772
- WO-A2-2008/147391
- ANDREAS KRELL, AXEL BALES: "Grain Size-Dependent Hardness of Transparent magnesium Aluminate Spinel", INTERNATIONAL JOURNAL OF APPLIED CERAMIC TECHNOLOGY, Bd. 8, Nr. 5, 28. Oktober 2010 (2010-10-28), Seiten 1108-1114, XP002686620, DOI: 10.1111/j.1744-7402.2010.02583.x

## Beschreibung

Die Erfindung bezieht sich auf das Gebiet der Keramik und betrifft transparente Komposit-Scheiben für Sicherheitsfenster, die üblicherweise aus mehreren Lagen von ggf. untereinander durch ein Verbindungsmittel verbundener Keramik-, Glas- und Kunststoff-Platten aufgebaut sind und eine erhöhte Belastbarkeit aufweisen. Sie werden als transparente Schutzkomponenten insbesondere dort eingesetzt, wo eine leichte und sichere transparente Scheibe oder Fenster erwünscht ist, wie für Fahrzeuge, Flugobjekte oder Personenschutz.

Sicherheitsfenster, insbesondere als durchschusshemmender transparenter Schutz, unterliegen insbesondere für Fahrzeuge und Flugobjekte ständig steigenden Forderungen nach geringerem Gewicht oder - mit Blick auf den Platzbedarf - dünneren Scheiben bei gleichzeitig wachsendem Sicherheitsbedürfnis. Traditionell bekannte Panzerglasfenster können diese Forderungen nicht für alle Einsatzfälle erfüllen, so dass seit ca. 10 Jahren breite internationale Entwicklungen zur Substitution vor allem der äußeren Schicht (bzw. Schichten) laminierter Komposit-Fenster durch ein- oder polykristalline keramische Materialien bekannt sind. Eine Beschreibung des typischen Designs und einer ballistischen Erprobung wurde z.B. von Patel u.a. für ein Keramik/Glas/Polycarbonat-Kompositfenster gegeben, bei dem die Keramik ein gesintertes (d.h. polykristallines) AION-Material war (P.J. Patel u.a.: AMPTIAC Newsletter 4(2000)3, 1-5+13).

Nach der EP 2 275 772 A1 ist eine transparente Komposit-Scheibe für Sicherheitsfenster bekannt.

Nach der EP 0 521 473 ist eine ein mehrschichtiges, kristallines Siliziumkarbid enthaltende Zusammensetzung bekannt, bei der Siliziumkarbid auf einem Einkristall-Substrat aufgewachsen ist, wobei das Siliziumkarbid monokristallin ist und das Einkristall-Substrat eine Gitterkonstante von 4,0 bis 5,2 x 10¹⁰ m oder ein ganzzahliges Vielfaches davon hat und ein Isolator ist.

Die Anzahl der für die keramische Komponente von Sicherheitsscheiben in Frage kommenden Material-Kandidaten ist bis heute recht übersichtlich und entspricht noch einer u.a. in US 7,584,689 B2 gegebenen Auflistung:
- farblose Al₂O₃-Einkristalle (meist als "Saphir" oder Korund bezeichnet),
- polykristalline Al₂O₃-Sinterkeramik (nur sehr begrenzt nutzbar, weil wegen der Doppelbrechung des Lichtes in den nicht-kubischen Korund-Kristalliten Streuverluste auftreten, die diese Keramik bei Dicken > 1 mm eher transluzent als transparent erscheinen lassen),
- polykristalline Sinterkeramik aus Aluminiumoxynitrid ("AION", kubisches Kristallsystem),
- polykristalline Sinterkeramik aus Magnesium-Aluminat-Spinell (meist als MgO·*n*Al₂O₃ mit *n*≈1 und daher oft als MgAl₂O₄ bezeichnet, kubisches Kristallgitter).

Die Vielzahl anderer bekannter transparenter Sinterkeramiken kubischer Kristallstruktur spielt aus preislichen Gründen oder wegen zu niedriger mechanischer Parameter für den transparenten Schutz bis heute keine Rolle.

Bekanntermaßen bezeichnen die Begriffe transparent oder Transparenz eine klare Durchsichtigkeit in Abgrenzung von nur transluzenten, dass heißt durchscheinenden Komporienten.

Die Entwicklung der Materialien auf diesem Gebiet konzentrierte sich in den letzten 10 Jahren vor allem unter Verweis auf kritisierte generelle Nachteile der Einkristalle (hohe Kosten bei wenig flexibler, schwieriger Herstellung größerer oder nicht-ebener Formen) stark auf das Gebiet der polykristallinen Sinterkeramiken.

Im Ergebnis überraschten diese mit dem Befund, dass
- nicht nur transparente *Al₂O₃*-Sinterkeramik (mit Sub-µm-Gefüge) sich als ballistisch stabiler als Al₂O₃-Einkristalle unterschiedlicher Orientierung erwies (was angesichts höherer Härte, Festigkeit und Bruchzähigkeit der feinkristallinen Sinterkeramik als naheliegend erscheinen könnte),
- sondern auch transparente feinkristalline *Spinell*-Keramiken im ballistischen Test eine höhere Schutzwirkung als Saphir aufweisen - trotz *niedrigeren* Niveaus fast aller mechanischen Kenngrößen der Spinell-Keramiken (A. Krell u.a.: J. Europ. Ceram. Soc. 29 (2009) 2, 275-281).

Dieses Verhalten wird bisher dahingehend interpretiert, dass die polykristallinen Sinterkeramiken beim Auftreffen eines Projektils ein für die Schutzwirkung günstigeres Bruchverhalten zeigen als Einkristalle, so dass anders geformte Fragmente gebildet werden und schließlich die polykristalline Scheibe oder ihre Fragmente stärker auf das Projektil einwirken, als dies bei Verwendung von Einkristallen der Fall ist (A. Krell u.a.: Am. Ceram. Soc. Bull 86 (2007) 4, 9201-9207; E. Strassburger u.a.: in: 25th International Symposium on Ballistics, Peking 2010, S. 1172-1179).

Anderseits hat die Forschung der letzten Jahre aber auch ernsthafte Schwierigkeiten der Entwicklung geeigneter polykristalliner Schutzkeramiken gezeigt. Diese betreffen sowohl die Transparenz wie auch den erreichbaren Grad an Defektfreiheit (d.h. die Minimierung von Anzahl und Größe sichtbarer Defekte im durchsichtigen Material). So erscheinen Literatur-Ergebnisse mit einer In-Line-Transmission von z.B. 82% für eine 1 mm dünne Spinell-Probe zwar recht nahe der theoretisch erreichbaren Obergrenze von 87%, könnten aber für eine Nutzung als transparenter Schutz dennoch unzureichend sein: wenn zum sicheren Stopp eines mit 850 m/s auftreffenden Stahlkernprojektils eine Keramik-Dicke von z.B. 3.5 mm erforderlich ist (was für viele reale Anwendungen eine *untere* Grenze darstellen dürfte), so hätte die angesprochene Spinell-Keramik bei dieser Dicke nur noch eine Transmission von {(82/87)^{3.5}}. 87% = 71% - was zusammen mit den ebenfalls nicht vollkommen vernachlässigbaren Verlusten an den anderen Komponenten des Komposit-Fensters (Glas- und Polycarbonat-Backing, Grenzflächen) zumindest für eine Straßenverkehrszulassung grenzwertig werden könnte.

Hinzu kommt die Erfahrung, dass die polykristallinen Sinterkeramiken nicht selbstverständlich gleichermaßen frei von sichtbaren Defekten herstellbar sind, wie dies von der Einkristallzüchtung bekannt ist. Lieferanforderungen wie "keine Blasen, Einschlüsse oder milchigen Trübungen" werden für polykristalline Sinterkeramiken in dieser Absolutheit kaum zu erfüllen sein.

Obwohl in letzterer Hinsicht die Einkristallzüchtung gewisse Vorteile bietet, ist im Ergebnis der o.a. vergleichenden ballistischen Tests von Ein- und Polykristallen nicht nur der Al₂O₃-Einkristall in der Diskussion transparenten keramischen Schutzes immer weniger beachtet worden. Da generell eine hohe Härte neben hohem Elastizitätsmodul als wichtigste Voraussetzung hoher Schutzwirkung gilt, die
- Härten *aller* Einkristalle aber grundsätzlich *unter* den der entsprechenden dichtgesinterten polykristallinen Keramiken liegen (zumindest beim Vergleich mit feinkörnigeren Gefügen) und
- im Vergleich mit Saphir alle anderen mit vertretbarem Aufwand herstellbaren transparenten keramischen Einkristalle noch weit geringere Härten als der Al₂O₃-Einkristall aufweisen,
ist die Möglichkeit einer Entwicklung, Herstellung und sinnvollen Verwendung transparenter Komposit-Fenster mit *anderen* als Al₂O₃-Einkristallen bisher nicht in Erwägung gezogen worden.

Angesichts der beschriebenen Grenzen bisheriger Entwicklungen mit ein- wie mit polykristallinen Keramiken besteht die Aufgabe der Erfindung in der Angabe einer transparenten Komposit-Scheibe für Sicherheitsfenster, welche die bisherigen Transmissions- und Qualitätsnachteile transparenter polykristalliner Keramiken ebenso vermeidet wie die Nachteile in der Schutzwirkung, wie sie Al₂O₃-Einkristalle im Vergleich mit feinkristallinen transparenten Al₂O₃- oder Spinell-Sinterkeramiken zeigen.

Die Aufgabe wird durch die in den Ansprüchen angegebene Erfindung gelöst. Vorteilhafte Ausgestaltungen sind Gegenstand der Unteransprüche.

Bei der erfindungsgemäßen transparenten Komposit-Scheibe für Sicherheitsfenster besteht der Komposit aus mehreren Lagen, die hintereinander angeordnet sind, und mindestens eine Lage eine Platte oder mosaik- oder serienmäßig angeordnete Platten aus einkristallinem Magnesium-Aluminat-Spinell sind.

Vorteilhafterweise bestehen die weiteren Lagen aus Gläsern, Keramiken und/oder Kunststoffen.

Ebenfalls vorteilhafterweise sind die Lagen durch ein haftvermittelndes Verbindungsmittel miteinander verbunden.

Weiterhin vorteilhafterweise sind eine oder mehrere Lagen von mosaik- oder serienmäßig angeordnete Platten aus einkristallinem Magnesium-Aluminat-Spinell zu einer größeren transparenten Komposit-Scheibe zusammengesetzt.

Vorteilhaft ist es auch, wenn Fugen zwischen Platten aus einkristallinem Magnesium-Aluminat-Spinell jeweils nach außen von mindestens einer größeren Deckplatte aus einem transparenten Material bedeckt sind.

Ebenfalls vorteilhaft ist es, wenn die mindestens eine Platte aus einkristallinem Magnesium-Aluminat-Spinell mit <111 >-Orientierung der Flächen-Normalen besteht.

Weiterhin von Vorteil ist es, wenn der einkristalline Magnesium-Aluminat-Spinell eine chemische Zusammensetzung MgO·nAl₂O₃ mit einem Parameter n im Bereich von 0,9 bis 3,5 aufweist.

Erfindungsgemäß erfolgt die Verwendung der transparenten Komposit-Scheibe für Sicherheits- und/oder Schutzanwendungen für Scheiben oder Fenster im zivilen und militärischen Bereich.

Vorteilhafterweise erfolgt die Verwendung für Einsatzbereiche, in denen leichte Komposit-Scheiben mit besonders hoher Defektfreiheit und hoher Schutzwirkung benötigt werden.

Weiterhin vorteilhafterweise erfolgt die Verwendung für Sicherheits- und/oder Schutzscheiben oder -fenster in Fahrzeugen, Flugobjekten oder im Personenschutz.

Mit der erfindungsgemäßen Lösung wird erstmals eine transparente Komposit-Scheibe für Sicherheitsfenster angegeben, die die bisherigen Transmissions- und Qualitätsnachteile transparenter polykristalliner Keramiken ebenso vermeidet wie die Nachteile der Schutzwirkung, wie sie Al₂O₃-Einkristalle im Vergleich mit feinkristallinen transparenten Al₂O₃- oder Spinell-Sinterkeramiken zeigen.

Erreicht wird dies durch eine transparente Komposit-Scheibe, bei der der Komposit aus mehreren Lagen besteht, die hintereinander angeordnet sind, und von denen mindestens eine Lage aus einer oder mehreren mosaik- oder serienmäßig angeordneten Platten aus einkristallinen Magnesium-Aluminat-Spinell besteht.

Überraschenderweise konnte in Abkehr von allen bisher bekannten Überlegungen zur Entwicklung von Komposit-Fenstern zur Anwendung als transparenter Schutz die Aufgabe erfindungsgemäß dadurch gelöst werden, dass eine transparente Komposit-Scheibe mit der Abfolge
- einer optionalen äußeren Deckplatte, vorteilhafterweise aus relativ dünnem mineralischen Glas,
- der Besonderheit einer Platte oder einer oder mehreren Lagen von Platten aus einkristallinem Magnesium-Aluminat-Spinell,
- einem im Allgemeinen mehrfach laminierten Glas-Backing und
- einer rückwärtigen Platte aus einem transparenten Polymer (z.B. Polycarbonat),
entweder durch eine Fassung oder, vorteilhafterweise, durch möglichst dünne Schichten (≤ 0.8 mm, vorzugsweise ≤ 0,2 mm) eines im Brechungsindex angepassten transparenten Klebers als Verbindungsmittel verbunden und zusammengehalten wird. Die Verwendung solcher Kleber ist allgemein bekannt (EP-2275772 A1, US 7,584,689 B2 und US 2009/0320675 A1). Alternativ sind auch kleber-freie chemisch-aktivierte Fügungen nutzbar (C. Myatt u.a., Precision Photonics, Doc. #20060101), deren Anwendbarkeit für polykristalline (gesinterte) Magnesium-Aluminat-Keramiken von R.O. Loutfy beschrieben wurde (www.virtualacquisitionshowcase.com/document/1480/briefing). Speziell die Bindung der Stoß-Fugen benachbarter einkristalliner Magnesium-Aluminat-Spinell-Platten kann auch durch keramische Füge-Prozesse erzeugt werden, wie z.B. in US 2011/0039094 A1 oder für Saphir-Einkristallplatten von McGuire u.a. beschrieben (Proc. SPIE AeroSense Symposium, Orlando, FL, April 16, 2001) oder auch durch - z.B. auch Laser-gestütztes - Diffusionsfügen (diffusion bonding).

Dabei können die erfindungsgemäßen transparenten Komposit-Scheiben eine Platte oder eine oder mehrere Lagen von Platten aus einkristallinem Magnesium-Aluminat-Spinell, bevorzugt mit einem Mosaik-Aufbau oder einer serienmäßigen Anordnung auf einem Backing, enthalten. Ein solcher Aufbau ist beispielsweise in US - 7,584,689 B2, US - 2009/0320675 A1 oder DE 20 2008 014 264 U1 beschrieben. Eine oder mehrere solcher Komposit-Scheiben können auch zu einem größeren Fenster verarbeitet werden.

Bei einem erfindungsgemäßen Aufbau der Komposit-Scheibe mit mehreren mosaik- oder serienmäßig nebeneinander angeordneten Platten aus einkristallinem Magnesium-Aluminat-Einkristall ist es vorteilhaft, wenn diese zum Schutz eventueller Fugen noch von einer Deck-Platte aus relativ dünnem mineralischen Glas bedeckt sind.

Überraschenderweise zeigten Beschussversuche mit 7,62mm x 51APFN-Projektilen (mit Stahlkern) bei 840 m/s Projektil-Geschwindigkeit in DoP-Tests ("Depth of Penetration") mit Platten aus *einkristallinem* Magnesium-Aluminat-Spinell Al-reicher Zusammensetzung (ca. MgO·3Al₂O₃) eine *geringere* Eindringtiefe der Projektilfragmente in zur Messung der Schutzwirkung dahinterstehende Backings als für alle vergleichend erprobten *polykristallinen* SinterspinellKeramiken gleicher Dicke (unabhängig von deren Korngrößen [0,4-70 µm] und Vickers-Härten [mit Prüflast 98,1 N: HV10 = 12.0-14.7 GPa]; die Härte des geprüften einkristallinen Magnesium-Aluminat-Spinells war mit HV10 = 11.0 GPa signifikant geringer).

Die Orientierung der erfindungsgemäßen Platten aus einkristallinem Magnesium-Aluminat-Spinell in den transparenten Komposit-Scheiben ist für Durchsichtigkeit und Schutzwirkung ohne größere Bedeutung, allerdings sind bisher kaum Magnesium-Aluminat-Spinelle anderer als <111> oder <100> Züchtungsrichtung bekannt geworden, so dass beim Zerteilen senkrecht zur Wachstumsrichtung i.a. planare Oberflächen vorliegen, die (111)- oder (100)-Ebenen entsprechen (mit <111> bzw. <100> als Orientierung der Flächen-Normalen). Da Magnesium-Aluminat-Spinelle in <111>-Richtung bisher einfacher zu züchten waren, ist dies die ganz überwiegend verbreitete Orientierung und kann daher auch vorteilhafterweise eingesetzt werden.

Ebenso unerheblich für die erstaunlich hohe Schutzwirkung ist die chemische Zusammensetzung des erfindungsgemäßen Magnesium-Aluminat-Spinells MgO·*n*Al₂O₃, die im Bereich von etwa *n* = 0,9-3,5 solange frei gewählt werden kann, wie die Züchtungsbedingungen noch zu einem klar durchsichtigen einphasigen Material ohne MgO- oder Al₂O₃-Ausscheidungen führen. Zwar sinkt mit steigenden Al₂O₃-Gehalt (steigendem n) die Härte des Spinells (A. Krell u.a.: Int. J. Appl. Ceram. Technol. 8 (2011) DOI:10.1111/j.1744-7402.2010.02583.x), der Vorteil der Schutzwirkung des Einkristalls gegenüber den polykristallinen Sinterkeramiken war in den Beschusstests jedoch selbst dann signifikant, wenn, wie oben beschrieben, ein besonders Al-reicher (d.h. weniger harter) Spinell-Einkristall mit besonders harten (d.h. feinkristallinen) Sinterspinellkeramiken einer Zusammensetzung nahe n=1 verglichen wurde.

Die zu fordernde Reinheit der für erfindungsgemäße Komposit-Scheiben einsetzbaren einkristallinen Magnesium-Aluminat-Spinelle ergibt sich ausschließlich aus den Forderungen der jeweiligen Anwender nach Farblosigkeit; so führen geringe Eisen- und/oder Cr-Verunreinigungen von z.B. 5 ppm zu einer mäßigen, erst bei Dicken > 10 mm auffälligeren rosa-bräunlichen Färbung. Üblicherweise ist die Summe aller kationischen Verunreinigungen kleiner 1000 ppm (0,1 Ma.-%), vorteilhafterweise < 500 ppm mit Si als Hauptverunreinigung und einer Summe von Fe+Cr < 10 ppm.

Die oben angeführte Beobachtung einer hohen Schutzwirkung speziell der einkristallinem Magnesium-Aluminat-Spinelle ist umso überraschender, als ihr nicht nur das andere Verhalten der *polykristallinen* Spinell-Keramiken gegenübersteht sondern auch die bekanntlich signifikant *ungünstigere* ballistische Stabilität der Al₂O₃-*Einkristalle* - *obwohl* letztere mit gegenüber dem einkristallinem Magnesium-Aluminat-Spinell gravierend höherer Härte und höherem Elastizitätsmodul im Vorteil sein sollten. Eine umfassende Erklärung der überraschenden Beobachtung höherer Schutzwirkung des in Härte, E-Modul und Festigkeitsparametern eher benachteiligten Spinell-Einkristalls ist naturgemäß noch nicht möglich: da die Möglichkeit einer die polykristallinen Spinellkeramiken und auch den Saphir übertreffenden Schutzwirkung einkristallinen Magnesium-Aluminat-Spinells bisher noch nirgends in Erwägung gezogen wurde, fehlte bisher jeder Anlass zu den für eine eventuelle Erklärung erforderlichen Untersuchungen. Einziger Ansatzpunkt ist momentan der Umstand, dass einkristalliner Magnesium-Aluminat-Spinell für seine Spaltbarkeit entlang von {001}-Ebenen bekannt ist (A. Kuramata u.a.: Appl. Phys. Lett. 67 (1995) 17, 2521-2523), während der Al₂O₃-Einkristall (Korund) als nicht-spaltbar gilt (z.B. http://en.wikipedia.org/wiki/Sapphire; selbst Saphir-Ebenen niedrigsten Rissausbreitungswiderstandes zeigen einen kritischen Spannungsintensitätsfaktor K_{lc} von ca. 2-2,5 MPa√m [A. Krell u.a.: phys. stat. sol. (a) 52 (1979) K45-49], also immer noch auf dem Niveau spröderer *polykristalliner* Keramiken). Diese leichte Spaltfähigkeit könnte bei Aufprall eines Projektils im einkristallinen Magnesium-Aluminat-Spinell zu schnellerer, weiterreichender Rissausbreitung führen als in Saphir, und für schnellere Rissausbreitung sagt ein bruchmechanisches Modell die Bildung größerer Fragmente des zerfallenden spröden Körpers voraus (Zhang u.a.: Transactions of the ASME 70 (2003) 5, 454-457). Größere Keramik-Fragmente aber unterliegen einer größeren Masseträgheit und könnten, nach einem anderen Modell, auf diese Weise eine größere abrasive Einwirkung auf das eindringende Projektil ausüben (A. Krell: Am. Ceram. Soc. Bull. 86 (2007) 4, 9201-9204).
Weitere Untersuchungen zur Klärung der überraschenden Wirkungen sind also künftig erforderlich.

Unter den Sicherheitsanwendungen der erfindungsgemäßen transparenten Komposit-Scheiben sollen im Rahmen dieser Erfindung Anwendungen im zivilen und militärischen Bereich verstanden werden, bei denen insbesondere leichte Komposit-Scheiben mit guter Transparenz und hoher Schutzwirkung gefragt sind und die insbesondere für Sicherheits- oder Schutzscheiben oder -fenster in Fahrzeugen, Flugobjekten oder für den Personenschutz eingesetzt werden können.

Im Weiteren wird die Erfindung an einem Ausführungsbeispiel näher erläutert.

### Dabei zeigen

Fig. 1 In-Line-Transmission eines 4,4 mm dicken einkristallinen Magnesium-Aluminat-Spinells im Vergleich mit der theoretischen Transmission. und
Fig. 2 Gemessenen Resteindringtiefen in ein Glas-Backing in Abhängigkeit von der Dicke der zu testenden Platten

### Beispiel 1

Eine transparente Komposit-Scheibe wurde folgendermaßen aufgebaut:
- Platte der Dicke 4,4 mm aus poliertem einkristallinem Magnesium-Aluminat-Spinell der Zusammensetzung MgO·*n*Al₂O₃ mit *n*=3, die laterale Oberfläche zeigte die kristallographische Orientierung (111),
- 3-fach laminiertes Glas-Backing (9 mm Dicke jeder Schicht),
- Rückenplatte aus Polycarbonat (3 mm Dicke),
verbunden jeweils durch eine 0,1 mm dünne Schicht aus einem organischen, unter UV-Licht konsolidiertem transparenten Kleber (Delo Photobond GB310).

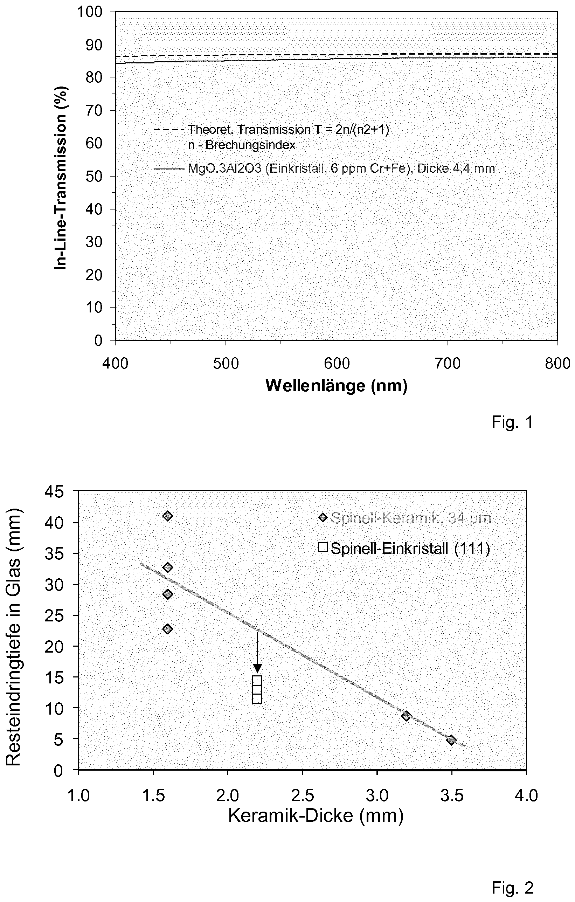

Zuvor war die In-Line-Transmission der 4,4 mm dicken Platte aus poliertem einkristallinem Magnesium-Aluminat-Spinell bei Durchstrahlung in <111>-Richtung nahe der theoretischen (vom wellenlängenabhängigen Brechungsindex bestimmten) Transmission mittels eines Cary 4000 Spectrometer der Fa. Varian Inc. (Mulgrave, Vic., Australia) ermittelt worden (Fig. 1).

Der Nachweis der überraschenderweise erhöhten Stabilität von transparenten Kompositen mit einkristallinem Magnesium-Aluminat-Spinell gegenüber solchen mit polykristallinen Magnesium-Aluminat-Sinterkeramiken oder mit Saphir (einkristallinem Al₂O₃) unterschiedlicher Orientierung erfolgte durch gesonderte Beschuss-Prüfungen vom DoP-Typ ("Depth of Penetration"). Gemessen wird hierbei die Resteindringtiefe eines Projektils (bzw. von Projektil-Trümmern) in ein massives Backing nach Durchschlagen der zu testenden Keramik- bzw. Einkristall-Platten bestimmter Dicke. Eine erhöhte mechanische Stabilität ist dabei durch niedrigere DoP gekennzeichnet.

Zur Bewertung der Stabilität ein- oder polykristalliner durchsichtiger Oxidmaterialien in transparenten Komposit-Scheiben ist naturgemäß ein DoP-Test mit transparentem Glas-Backing besonders geeignet. Die Genauigkeit korrekter Messungen der Eindringtiefen in sprödem, zersplitterndem Glas könnte jedoch auf Zweifel treffen, weshalb zusätzliche Tests mit metallischem Backing (einer Al-Legierung) erfolgten. Die Auswahl von Aluminium war dabei dadurch begründet, dass solche Legierungen mit E-Moduln von 70-100 GPa eine ähnliche Steifigkeit aufweisen wie Glas (60-80 GPa).
Alle Tests erfolgten mit 7,62mm x 51APFN-Stahlkernprojektilen bei einer Auftreffgeschwindigkeit von 840-850 m/s.

### (a) Vergleichende Stabilitätsprüfung vor Al-Backing

Im Vergleich
- mit 4,45 mm dicken Platten polykristalliner Spinell-Keramiken unterschiedlicher Korngröße und Härte aber einheitlicher Zusammensetzung MgO·*n*Al₂O₃ mit *n=1*
- wie auch mit Al₂O₃-Einkristallen unterschiedlicher Orientierung und 4 mm Dicke (entsprechend einem gleichen Flächengewicht verglichen mit den Spinell-Platten)
zeigte eine 4,45 mm dicke Platte aus poliertem einkristallinem Magnesium-Aluminat-Spinell trotz ihrer geringen Härte die größere Schutzwirkung:

| Keramik | | Härte HV10 | Eindringtiefe t_{R} |
|---|---|---|---|
| (111)-Einkristall MgO·3Al₂O₃ | | 11.0 GPa | 6.0 mm |
| | | | |
| Polykristalline Sinter-Keramiken (Zusammensetzung MgO·1Al₂O₃) | | | |
| mit mittl. Korngröße | 0.35 µm | 14.7 GPa | 8.0 mm |
| | 1.40 µm | 13.6 GPa | 7.8 mm |
| | 13.2 µm | 12.7 GPa | 7.1 mm |
| | 73 µm | 12.0 GPa | 8.2 mm |
| | | | |
| (0001)-α-Al₂O₃-Einkristall | | 13.4 GPa | 16.5 mm |
| (1120)-α-Al₂O₃-Einkristall | | 14.9 GPa | 11.0 mm |

### (b) Vergleichende Stabilitätsprüfung vor Glas-Backing

Die Stabilität von Platten aus einkristallinem Magnesium-Aluminat-Spinell (Orientierung (111), Zusammensetzung MgO·3Al₂O₃) wurde hier mit der Stabilität einer transparenten polykristallinen Spinell-Sinterkeramik verglichen, deren mittlere Korngröße durch geeignete thermische Behandlung auf 34 µm eingestellt worden war. Die Härte der Sinterkeramik betrug dadurch nur noch HV10 = 12.3 ± 1.0 GPa, war damit aber immer noch höher als die des geprüften einkristallinen Magnesium-Aluminat-Spinells (HV10 = 11.0 ± 0.3 GPa).

Dennoch weist Fig. 2 auch in diesen Tests für den einkristallinen Magnesium-Aluminat-Spinell die - dickenbezogen - geringere Eindringtiefe der Projektiltrümmer im Glasbacking und somit eine überraschenderweise höhere Stabilität aus.

## Patentansprüche

1. Transparente Komposit-Scheibe für Sicherheitsfenster, wobei der Komposit aus mehreren Lagen besteht, die hintereinander angeordnet sind, und von denen mindestens eine Lage aus einer Platte oder aus mosaik- oder serienmäßig angeordneten Platten aus einkristallinem Magnesium-Aluminat-Spinell besteht.

2. Transparente Komposit-Scheibe nach Anspruch 1, bei der die weiteren Lagen aus Gläsern, Keramiken und/oder Kunststoffen bestehen.

3. Transparente Komposit-Scheibe nach Anspruch 1, bei der die Lagen durch ein haftvermittelndes Verbindungsmittel miteinander verbunden sind.

4. Transparente Komposit-Scheibe nach Anspruch 1, bei der eine oder mehrere Lagen von mosaik- oder serienmäßig angeordnete Platten aus einkristallinem Magnesium-Aluminat-Spinell zu einer größeren transparenten Komposit-Scheibe zusammengesetzt sind.

5. Transparente Komposit-Scheibe nach Anspruch 1, bei der Fugen zwischen Platten aus einkristallinem Magnesium-Aluminat-Spinell jeweils nach außen von mindestens einer größeren Deckplatte aus einem transparenten Material bedeckt sind.

6. Transparente Komposit-Scheibe nach Anspruch 1, bei der die mindestens eine Platte aus einkristallinem Magnesium-Aluminat-Spinell mit <111>-Orientierung der Flächen-Normalen besteht.

7. Transparente Komposit-Scheibe nach Anspruch 1, bei der der einkristalline Magnesium-Aluminat-Spinell eine chemische Zusammensetzung MgO·nAl₂O₃ mit einem Parameter n im Bereich von 0,9 bis 3,5 aufweist.

8. Verwendung der transparenten Komposit-Scheibe nach Anspruch 1 für Sicherheits- und/oder Schutzanwendungen für Scheiben oder Fenster im zivilen und militärischen Bereich.

9. Verwendung nach Anspruch 8 für Einsatzbereiche, in denen leichte Komposit-Scheiben mit besonders hoher Defektfreiheit und hoher Schutzwirkung benötigt werden.

10. Verwendung nach Anspruch 8 für Sicherheits- und/oder Schutzscheiben oder -fenster in Fahrzeugen, Flugobjekten oder im Personenschutz.

## Claims

1. Transparent composite pane for safety windows, where the composite is composed of a plurality of layers arranged in succession, of which at least one layer is composed of a sheet, or sheets arranged serially or in the form of a mosaic, made of monocrystalline magnesium aluminate spinel.

2. Transparent composite pane according to Claim 1, in which the other layers are composed of glasses, ceramics and/or plastics.

3. Transparent composite pane according to Claim 1, in which an adhesion-promoting bonding agent has been used to bond the layers to one another.

4. Transparent composite pane according to Claim 1, in which one or more layers of sheets made of monocrystalline magnesium aluminate spinel and arranged serially or in the form of a mosaic has/have been assembled to give a transparent composite pane of larger dimension.

5. Transparent composite pane according to Claim 1, in which joints between sheets made of monocrystalline magnesium aluminate spinel have in each case been externally covered by at least one outer sheet of larger dimension made of a transparent material.

6. Transparent composite pane according to Claim 1, in which the at least one sheet made of monocrystalline magnesium aluminate spinel is present with <111> orientation in respect of the surface normal.

7. Transparent composite pane according to Claim 1, in which the chemical composition of the monocrystalline magnesium aluminate spinel is MgO•nAl₂O₃ with a parameter n in the range from 0.9 to 3.5.

8. Use of the transparent composite pane according to Claim 1 for safety applications and/or protective applications for panes or windows in the civilian or military sector.

9. Use according to Claim 8 for application sectors which require lightweight composite panes with a particularly high level of freedom from defects and providing a high level of protection.

10. Use according to Claim 8 for safety panes, safety windows, protective panes and/or protective windows in vehicles or aircraft or in personal protection.

## Revendications

1. Vitre composite transparente pour fenêtre de sécurité, le composite étant constitué par plusieurs couches, qui sont disposées les unes derrières les autres et dont au moins une couche est constituée par une plaque ou des plaques disposées en mosaïque ou en série en spinelle monocristallin de magnésium-aluminate.

2. Vitre composite transparente selon la revendication 1, dans laquelle les autres couches sont constituées par des verres, des céramiques et/ou des matériaux synthétiques.

3. Vitre composite transparente selon la revendication 1, dans laquelle les couches sont reliées les uns aux autres à l'aide d'un moyen de liaison promoteur d'adhérence.

4. Vitre composite transparente selon la revendication 1, dans laquelle une ou plusieurs couches des plaques disposées en mosaïque ou en série en spinelle monocristallin de magnésium-aluminate sont assemblées en une vitre composite transparente plus grande.

5. Vitre composite transparente selon la revendication 1, dans laquelle les joints entre des plaques en spinelle monocristallin de magnésium-aluminate sont à chaque fois recouverts, vers l'extérieur, par au moins une plaque de recouvrement plus grande en un matériau transparent.

6. Vitre composite transparente selon la revendication 1, dans laquelle ladite au moins une plaque est en spinelle monocristallin en magnésium-aluminate présentant une orientation <111> de la normale par rapport à la surface.

7. Vitre composite transparente selon la revendication 1, dans laquelle le spinelle monocristallin en magnésium-aluminate présente une composition chimique MgO * nAl₂O₃, le paramètre n étant situé dans la plage de 0,9 à 3,5.

8. Utilisation de la vitre composite transparente selon la revendication 1 pour des utilisations de sécurité et/ou de protection pour des vitres ou des fenêtres dans le domaine civil et militaire.

9. Utilisation selon la revendication 8 pour des domaines d'utilisation dans lesquels des vitres composites légères présentant une absence de défaut particulièrement élevée et un effet de protection élevé sont nécessaires.

10. Utilisation selon la revendication 8 pour des vitres ou des fenêtres de sécurité et/ou de protection dans des véhicules, des objets volants ou la protection de personnes.
